# DEMANDE DE BREVET EUROPEEN

(11) **EP 4 280 828 A1**
(43) Date de publication de la demande: **22.11.2023**
(21) Numéro de dépôt: 23173377.5
(22) Date de dépôt: 15.05.2023
(51) Int. Cl.: H05K 1/14, H05K 3/36, H05K 3/30

(54) **RACCORDEMENT ELECTRIQUE AMELIORE ENTRE UN CIRCUIT FLEX ET UN CIRCUIT RIGIDE, BROCHE DE CONNEXION ASSOCIEE**

(30) Priorité: 20.05.2022 FR 2204879
(71) Demandeur: BeLink Solutions, 72400 La Ferte-Bernard (FR)
(72) Inventeur: BALL, Pierre, 49100 ANGERS (FR); BARILLER, Jean-Marie, 72300 SABLE SUR SARTHE (FR); LARDEUX, Laurent, 72400 LA FERTE-BERNARD (FR); LE CORSU, Jean-Victor, 72390 DOLLON (FR)
(74) Mandataire: Santarelli

(57) **Abrégé**

Un raccordement électrique selon l'invention comprend la superposition d'un circuit imprimé flexible (200) sur un circuit imprimé rigide (100) en alignant un trou (231) réalisé au niveau d'une zone de contact (230) du circuit flexible en regard d'un trou métallisé (131) du circuit rigide, puis l'engagement d'une broche de connexion (300) en matériau conducteur par le trou du circuit flexible de sorte qu'une première extrémité press-fit (310) de la broche de connexion s'emmanche dans le trou métallisé, et qu'une extrémité opposée (320) de la broche de connexion maintient, par appui contre la zone de contact, le circuit flexible contre le circuit rigide. En étant en contact avec la zone de contact et avec la métallisation du trou métallisé, la broche de connexion réalise une connexion électrique entre les deux circuits imprimés, sans avoir recours à un composant additionnel de connexion sur le circuit flexible.

## Description

### Domaine technique

La présente invention concerne le raccordement électrique de circuits imprimés ou PCB (pour « printed circuit board » en terminologie anglo-saxonne).

### Technique antérieure

Un circuit imprimé est constitué en général de couches isolantes et de pistes électriques auxquelles des composants électroniques peuvent être connectés dans le but de réaliser un circuit électronique complexe.

Selon la rigidité du support isolant, le circuit imprimé peut être dit « rigide » ou « flexible ».

Un circuit imprimé rigide est typiquement constitué d'un substrat en résine époxyde et présente une épaisseur variable, par exemple souvent entre 0,8 et 2,4 mm.

Un circuit imprimé flexible ou « souple » (« soft PCB » or « flex PCB ») est fabriqué à partir de matière isolante fine. Il présente typiquement une épaisseur moindre (inférieure au millimètre), de l'ordre de 100 µm à 500 µm.

Les circuits imprimés flexibles se développent largement car leur faculté à se plier ou se courber trouve de nombreuses applications, aussi bien dans l'électronique grand public (téléphone, appareil photo, ordinateur, etc.) que dans les moyens de transport (véhicule, aviation, etc.).

Les circuits imprimés peuvent être simple face, double face et multicouche.

Il est une tendance à assembler des circuits imprimés rigides et flexibles, pour obtenir des circuits dits « flex-rigides ». Pour ce faire, il est nécessaire d'interconnecter deux circuits imprimés de nature différente, notamment de raccorder électriquement un circuit imprimé flexible à un circuit imprimé rigide.

Généralement des connecteurs particuliers pour flex PCB (ou nappe souple formant partie de contact du flex PCB) sont nécessaires qui permettent de connecter le circuit imprimé flexible par sertissage (« crimping » en terminologie anglo-saxonne). Ces connecteurs particuliers sont intégrés au circuit imprimé rigide par des techniques classiques, par exemple à l'aide de broches à emmanchement ou « press-fit » selon la terminologie anglo-saxonne.

On connaît la publication US 2019/0296464 qui décrit une méthode pour raccorder électriquement un circuit imprimé flexible à une plaque. Selon les modes de réalisation proposés, il est requis le couplage mécanique d'un composant additionnel en forme de manchon avec le circuit imprimé flexible, avant d'utiliser une broche press-fit pour connecter le circuit à la plaque.

L'ajout de ce composant additionnel est préjudiciable à plusieurs égards. D'une part, il induit des coûts supplémentaires. D'autre part, il requiert des étapes supplémentaires de brasage (« soft solder ») non compatibles avec tous les types d'isolant pour flex PCB (à raison des températures) et consommatrices de temps. Enfin, il crée, au niveau de la brasure, une zone de fragilité, susceptible de rompre selon les contraintes mécaniques endurées.

Il existe donc un besoin d'améliorer les techniques existantes de raccordement électrique d'un circuit imprimé flexible à un circuit imprimé rigide.

### Exposé de l'invention

Dans ce contexte, il est proposé un procédé de raccordement électrique d'un circuit imprimé flexible à un circuit imprimé rigide selon la revendication 1.

Un tel procédé comprend les étapes suivantes :
- présenter une zone de contact du circuit imprimé flexible, en regard d'un trou, généralement traversant, métallisé du circuit imprimé rigide,
- engager une broche de connexion en matériau conducteur au travers de la zone de contact du circuit imprimé flexible de sorte qu'une première extrémité de type à emmanchement ou « press-fit » de la broche de connexion s'emmanche (« press-fit »), i.e. s'engage en force pour rendre solidaires les pièces mécaniques par un ajustement bloqué, dans le trou métallisé du circuit imprimé rigide, et qu'une extrémité opposée de la broche de connexion maintient, par appui contre la zone de contact, le circuit imprimé flexible contre le circuit imprimé rigide de sorte à réaliser une connexion électrique entre les deux circuits imprimés.

Le circuit imprimé flexible est donc pris en sandwich entre le circuit imprimé rigide et la portion d'appui de la broche de connexion. Cette dernière établit, en soi, la connexion électrique entre les deux circuits, depuis la piste conductrice au niveau de la zone de contact jusqu'à la métallisation du trou métallisé du circuit imprimé rigide.

La zone de contact du circuit imprimé flexible est entendue comme une zone, généralement terminale, d'une piste conductrice ou électrique, prévue pour une interconnexion électrique avec un élément externe.

Selon l'invention, aucun composant additionnel n'est nécessaire sur le circuit imprimé flexible pour réaliser le raccordement électrique. En outre, ce dernier peut être effectué en une seule étape consistant à introduire ou engager la broche de connexion au travers de la zone de contact et du trou métallisé, tous deux alignés. Des gains en coûts et temps sont donc avantageusement obtenus.

Corrélativement, un assemblage électrique tel que défini par la revendication 10 est également proposé. L'assemblage électrique comporte :
- un circuit imprimé rigide présentant un trou métallisé,
- un circuit imprimé flexible présentant un trou traversant réalisé au niveau d'une zone de contact et disposé en regard du trou métallisé, et
- une broche de connexion en matériau conducteur dont une première extrémité de type à emmanchement ou « press-fit » de la broche est emmanchée dans le trou métallisé du circuit imprimé rigide, et une extrémité opposée maintient, par appui contre la zone de contact, le circuit imprimé flexible contre le circuit imprimé rigide de sorte à réaliser une connexion électrique entre les deux circuits imprimés.

En pratique, un assemblage entre un circuit imprimé flexible et un circuit imprimé rigide comporte un tel raccordement électrique en une pluralité de zones de contacts distinctes (et donc pluralité de trous métallisés correspondants du circuit imprimé rigide), typiquement associées à une pluralité de pistes conductrices.

Le trou traversant réalisé au niveau de la zone de contact peut être préexistant à l'assemblage ou résulter de cet assemblage par transpercement du circuit imprimé flexible par le broche de connexion.

Dans le procédé et l'assemblage électrique, une portion d'appui réalisant l'appui de l'extrémité opposée de la broche de connexion sur la zone de contact comporte au moins une protubérance, telle une dent, une demi-boule ou un picot semi-sphérique, orientée vers la première extrémité, donc dans le sens de l'appui vers le circuit rigide, lors du raccordement. Une disposition avec une protubérance pointue contribue au maintien d'une connexion électrique avec la zone de contact, malgré des contraintes et conditions extérieures difficiles (températures, pression mécanique) susceptibles d'altérer le contact par appui ou la tenue de la couche isolante du circuit imprimé flexible.

Des caractéristiques facultatives des modes de réalisation de l'invention sont définies dans les revendications annexées. Certaines de ces caractéristiques sont expliquées ci-dessous en référence à un procédé, tandis qu'elles peuvent être transposées en caractéristiques de dispositif (assemblage et broche de connexion).

Dans un mode de réalisation, le circuit imprimé flexible comporte un trou traversant réalisé au niveau de la zone de contact, lequel trou traversant est aligné avec le trou métallisé avant d'engager la broche de connexion. Un tel trou traversant est donc réalisé au préalable sur le circuit imprimé flexible. Une simple superposition verticale des deux trous est réalisée, puis la broche de connexion est introduite dans le trou ainsi formé.

Un trou au niveau de la zone de contact est préférentiellement réalisé au milieu d'une telle piste conductrice afin de favoriser les contacts électriques.

En variante à la présence d'un tel trou traversant, la zone de contact est dépourvue de percement préalable. Dans ce cas, la broche de connexion peut être pourvue d'une extrémité effilée, pointue et ou tranchante apte à transpercer le circuit imprimé flexible au niveau de la zone de contact lors de l'engagement de la broche de connexion. Un trou traversant est ainsi créé par l'engagement de la broche de connexion.

Selon une réalisation possible, ladite au moins une protubérance est une dent configurée pour transpercer une couche isolante et/ou une piste conductrice du circuit imprimé flexible au niveau de la zone de contact, lorsque la première extrémité est emmanchée dans le trou métallisé du circuit imprimé rigide. Un maintien amélioré est alors obtenu.

Selon une caractéristique particulière, ladite au moins une protubérance est une dent configurée pour transpercer le circuit imprimé flexible (donc dans son épaisseur entière) au niveau de la zone de contact, lorsque la première extrémité est emmanchée dans le trou métallisé, de sorte à réaliser un contact électrique avec une surface conductrice (par exemple un débordement de la métallisation du trou) du circuit imprimé rigide aux abords du trou métallisé. Cette disposition vise à améliorer le contact électrique de la broche avec le circuit imprimé rigide, tout en améliorant le maintien réciproque des deux circuits dans l'assemblage.

Selon une autre réalisation possible (et combinable), ladite au moins une protubérance comporte deux dents disposées de part et d'autre d'un axe longitudinal de la broche de connexion formé par lesdites deux extrémités. Grâce à cette symétrie, deux appuis sont réalisés, assurant un meilleur maintien des deux circuits en présence de contraintes mécaniques extérieures plus variées. En outre, l'engagement de la broche de connexion est facilité puisque cette dernière peut être insérées dans deux sens pour un résultat identique.

Selon une autre réalisation possible (et combinable), ladite au moins une protubérance comporte deux réseaux de dents disposés de part et d'autre d'un axe longitudinal de la broche de connexion formé par lesdites deux extrémités. Cette symétrie procure les mêmes avantages avec deux appuis, avec contact électrique multipoints qui améliore la connexion électrique. En outre, la présence de plusieurs (deux ou plus) dents de chaque côté assure un appui, et donc un maintien, amélioré.

Tout ou partie de ces dents peuvent être transperçantes de la couche isolante, de la piste conductrice ou du circuit imprimé flexible.

Dans un mode de réalisation qui peut être combiné, l'extrémité opposée de la broche de connexion comporte une portion d'appui élastiquement déformable agissant comme ressort pour exercer un effort d'appui pour ledit appui contre la zone de contact, lorsque la première extrémité est emmanchée dans le trou métallisé. Avantageusement, l'appui est amélioré, notamment lorsque l'assemblage subit des contraintes extérieures. Il en résulte un meilleur maintien mécanique des deux circuits et un meilleur contact électrique au niveau de la zone de contact (et donc une meilleure connexion électrique entre les deux circuits).

Selon une réalisation possible, la portion d'appui élastiquement déformable est symétrique par rapport à un axe longitudinal de la broche de connexion formé par lesdites deux extrémités. Cette symétrie procure les mêmes avantages avec deux appuis, que ceux exposés ci-dessus.

De façon incidente, l'invention propose également une broche de connexion d'un circuit imprimé flexible à un circuit imprimé rigide, adaptée au raccordement électrique et à l'assemblage ci-dessus, telle que définie par la revendication 11. La broche de connexion est réalisée en matériau conducteur et comprend :
- une première extrémité de type à emmanchement ou « press-fit » apte à être emmanchée dans un trou métallisé du circuit imprimé rigide, et
- une deuxième extrémité de connexion comprenant une portion d'appui configurée pour, lorsque la première extrémité traverse un trou réalisé au niveau d'une zone de contact du circuit imprimé flexible puis est emmanchée dans le trou métallisé du circuit imprimé rigide, maintenir, par appui contre la zone de contact du circuit imprimé flexible, le circuit imprimé flexible contre le circuit imprimé rigide de sorte à réaliser une connexion électrique entre les deux circuits imprimés,
broche de connexion dans laquelle la portion d'appui :
- comporte au moins une dent pour transpercer une couche isolante et/ou une piste conductrice du circuit imprimé flexible au niveau de la zone de contact, lorsque la première extrémité est emmanchée dans le trou métallisé.

Optionnellement, la portion d'appui est en outre élastiquement déformable agissant comme ressort pour exercer un effort d'appui pour ledit appui contre la zone de contact, lorsque la première extrémité est emmanchée dans le trou métallisé.

Dans un mode de réalisation, la broche de connexion est configurée en forme générale d'un T, le pied du T formant la première extrémité de type à emmanchement et la tête du T formant l'extrémité opposée maintenant, par appui contre la zone de contact, le circuit imprimé flexible contre le circuit imprimé rigide.

### Brève description des dessins

D'autres particularités et avantages de l'invention apparaîtront encore dans la description ci-après, illustrée par les figures ci-jointes qui en illustrent des exemples de réalisation dépourvus de tout caractère limitatif.
[Fig. 1] La **Figure 1** illustre deux circuits imprimés rigide et flexible à raccorder électriquement selon des modes de réalisation de l'invention.
[Fig. 2] La **Figure 2** illustre une superposition des deux circuits imprimés rigide et flexible pour les raccorder électriquement à l'aide d'une broche de connexion, selon des modes de réalisation de l'invention.
[Fig. 3] La **Figure 3** illustre un assemblage électrique résultant du raccordement électrique des deux circuits imprimés rigide et flexible selon des modes de réalisation de l'invention.
[Fig. 4] La **Figure 4** illustre des variantes d'une extrémité press-fit adaptable de broches de connexion selon des modes de réalisation de l'invention.
[Fig. 4a] La **Figure 4a** illustre une extrémité press-fit de type massive.
[Fig. 5] La **Figure 5** illustre des variantes d'une extrémité formant portion d'appui de broches de connexion selon des modes de réalisation de l'invention.

### Description détaillée

La présente invention concerne le raccordement électrique de circuits imprimés ou PCB (pour « printed circuit board » en terminologie anglo-saxonne), et plus particulièrement celui d'un circuit imprimé flexible ou « flex PCB » à un circuit imprimé rigide ou « rigid PCB ».

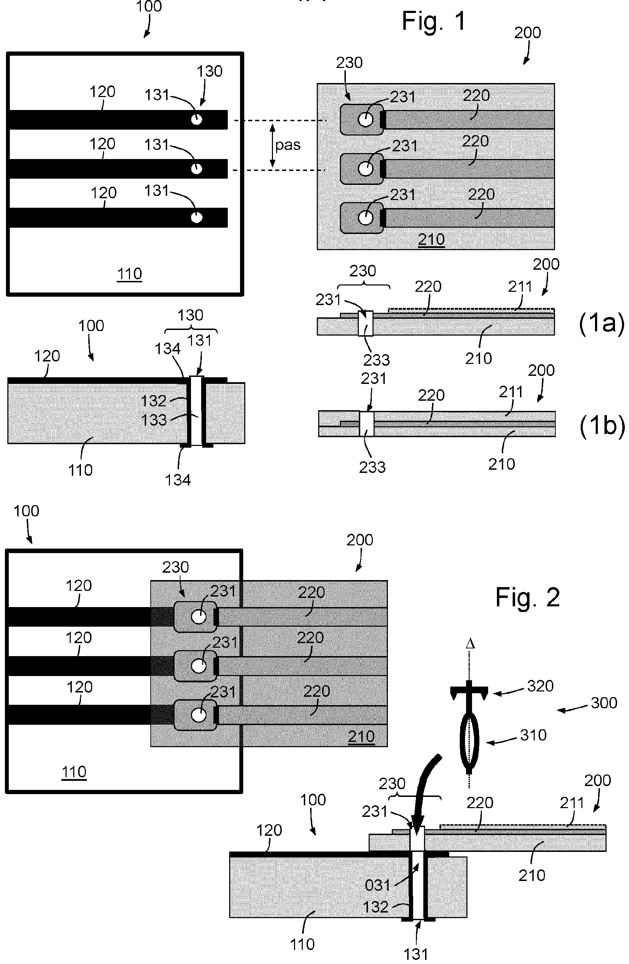

La **Figure 1** illustre un rigid PCB à gauche et un flex PCB à droite, dont on cherche à faire le raccordement électrique, c'est-à-dire à interconnecter les pistes conductrices. Pour des raisons de clarté, seules trois pistes conductrices sont illustrées sur ces circuits imprimés. De façon connue, ceux-ci peuvent comprendre un autre nombre de pistes (plus ou moins grand) et/ou des composants électroniques rapportés sur eux, par exemple par soudure ou à l'aide de broches de connexion de type à emmanchement ou « press-fit ».

Le rigid PCB 100 comprend un substrat 110, typiquement en FR4 ou autre substrat, sur lequel sont formées des pistes conductrices 120, par toute technique appropriée telle la gravure ou l'impression d'encre conductrice. Un rigid PCB présente typiquement une épaisseur variable, par exemple souvent entre 0,8 et 2,4 mm, conférant une rigidité appropriée pour l'insertion en force de broches « press-fit ».

Les pistes conductrices 120, de cuivre ou d'argent par exemple, se terminent par des zones de contact 130 prévues pour l'interconnexion avec le flex PCB 200. Bien qu'il soit illustré des zones de contact 130 constituant des portions terminales de pistes conductrices associées, une ou plusieurs ou chaque zone de contact peut constituer une portion intermédiaire de la piste conductrice. C'est-à-dire que des composants peuvent être rapportés sur la même piste conductrice des deux côtés de la zone de contact.

Chaque zone de contact 130 est adaptée à recevoir une broche « press-fit » comme décrite par la suite. La zone de contact 130 est ainsi formée d'un trou 131, préférentiellement traversant (en option seulement borgne), qui a été métallisé par toute technique connue. La métallisation permet le dépôt d'un matériau conducteur 132 dans le passage 133 du trou mais également sur les surfaces inférieure et supérieure 134 du rigid PCB 100 aux abords du trou 131, assurant un contact électrique avec la piste conductrice 120.

Dans l'exemple illustré, plusieurs trous métallisés 131 sont représentés qui sont alignés et répartis régulièrement sur le rigid PCB 100, selon un pas préfixé. Ce pas peut être ajusté en fonction d'une machine press-fit utilisée pour emmancher les broches press-fit dans ces trous 131. Des valeurs typiques de pas comprennent 2,54 mm, 2,20 mm, 2,00 mm voire d'autres valeurs jusqu'à 1,27 mm.

Dans les techniques classiques de press-fit, les trous métallisés 131 présentent typiquement un diamètre de 0,8 à 1,2 mm, par exemple de 1 à 1,1 mm. Bien entendu, le diamètre de ces trous est ajusté au diamètre des broches « press-fit » utilisées.

Bien que les trous métallisés 131 soient ici prévus pour des pistes conductrices 120, et donc des zones de contact 130, distinctes, il peut être prévu qu'une ou plusieurs zones de contact 130 (ou piste conductrice) comprennent chacune deux ou plusieurs trous métallisés. Cela permet d'améliorer la tenue mécanique de l'assemblage final entre les deux PCB, mais également d'améliorer la connexion électrique entre eux, notamment si une intensité importe de courant est destinée à circuler entre les deux PCB.

Le flex PCB 200 comprend un film de base 210 en plastique tel qu'en polyimide, en polyétheréthercétone (PEEK), en polycarbonate, en polyester type polyéthylène naphtalate (PEN) ou polyéthylène téréphtalate (PET), ou similaire, sur lequel sont formées des pistes conductrices 220, par toute technique appropriée telle la lamination, la gravure ou préférentiellement l'impression (sérigraphie) d'encre conductrice, par exemple d'une encre argent.

La face du flex PCB 200 présentant les pistes conductrices 220 est appelée surface supérieure, alors que la face inférieure du film de base 210 est appelée surface inférieure.

Les pistes conductrices 220, de cuivre ou d'argent par exemple, se terminent par des zones de contact 230 prévues pour l'interconnexion avec le rigid PCB 100.

La coupe (1a) sur la Figure représente un flex PCB 200 à base polycarbonate sur laquelle sont imprimées des pistes argent. La feuille polycarbonate 210 utilisée présente une épaisseur comprise entre 125 µm et 800 µm, de préférence entre 200 µm et 500 µm. La couche d'argent 220 présente une épaisseur de quelques µm, typiquement entre 8 et 15 µm. La piste d'argent 220 peut être recouverte, de façon optionnelle, d'une couche de protection isolante 211, typiquement une couche diélectrique d'une épaisseur de quelques µm à dizaines de µm, par exemple 8 à 40 µm. Avantageusement, le dépôt de la couche de protection isolante 211 peut être localisé de sorte à laisser la piste conductrice non recouverte au niveau de la zone de contact 230.

La coupe (1b) sur la Figure représente un flex PCB 200 à base polyimide ou PEEK 210 sur laquelle est collée une piste conductrice en cuivre 220, recouverte, par collage, d'un film isolant en PET 211. Dans un tel schéma, la base 210 présente une épaisseur de quelques dizaines de µm, par exemple 50 µm, la piste conductrice 220 une épaisseur de 35, 70 ou 105 µm et le film isolant 211 une épaisseur de quelques dizaines de µm, par exemple 50 µm. L'adhésif utilisé pour coller chaque couche peut être du type adhésif acrylique, tel un film Pyralux LF Sheet Adhesive (nom commercial) XXXX et présente une épaisseur de quelques dizaines de µm, par exemple 12 à 50 µm.

Le flex PCB 100 présente donc une épaisseur inférieure au millimètre, contribuant, avec la nature plastique de la base, à une souplesse ou flexibilité appréciable.

Les zones de contact 230 peuvent être vierges de tout percement.

Cependant, dans certains modes de réalisation tels qu'illustrés, chaque zone de contact 230 du flex PCB 200 présente un trou traversant 231 offrant un passage 233 cylindrique d'un diamètre similaire à celui des trous métallisés 131. Chaque trou traversant 231 est donc entouré d'une portion conductrice de la piste respective 220.

Dans l'exemple illustré, plusieurs trous traversant 231 sont représentés qui sont alignés et répartis régulièrement sur le flex PCB 200, selon le même pas que celui des trous métallisés 131 du rigid PCB 100.

De façon similaire au rigid PCB 100, une zone de contact 230 correspondant à une piste conductrice 220 peut présenter deux ou plus trous traversants 231 afin de réaliser plusieurs raccordements électriques selon l'invention par zone de contact.

Selon l'invention, les deux PCB sont raccordés électriquement sans ajout de connecteurs dédiés, ni sur le rigid PCB 100 ni sur le flex PCB 200. Pour ce faire, les zones de contact 130 et 230 sont d'abord superposées de sorte à présenter un trou 231 réalisé au niveau d'une zone de contact 230 du flex PCB 200, en regard d'un trou métallisé 131 du rigid PCB 100. C'est l'opération illustrée en **Figure 2****.**

Le flex PCB 200 est positionné surface inférieure sur le rigid PCB 100 de sorte que sa surface supérieure comprenant la zone de contact 230 (dégagée ou recouverte du film isolant 211) soit directement accessible et en contact avec la broche de connexion introduite, comme décrit par la suite.

Dans l'exemple illustré, les trois trous traversants 231 sont superposés aux trois trous métallisés 131, créant chacun un passage 031 continu au travers des deux PCB. Plus généralement, les zones de contact 230 sont superposées aux trous métallisés 131.

Le positionnement en superposition des deux PCB peut être réalisé manuellement ou automatiquement par une machine de press-fit utilisant par exemple des guides ou des moyens optiques d'alignement.

Selon l'invention toujours, le raccordement électrique des deux PCB est réalisé au niveau des trous superposés ainsi formés, à l'aide de broches de connexion en matériau conducteur dont un exemple de réalisation est illustré sur la **Figure 2** sous la référence 300. Les broches peuvent être insérées simultanément ou l'une après l'autre.

Une telle broche 300 est sensiblement allongée présentant deux extrémités (haute et basse sur la Figure) définissant un axe longitudinal Δ, typiquement de symétrie. La broche représentée est en forme générale d'un T.

Le pied 310 du T forme une première extrémité de type à emmanchement ou « press-fit » qui a vocation à être emmanchée dans un des trous métallisés 131 du rigid PCB 100. En engageant en force cette extrémité dans le trou métallisé, la broche 300 et le rigid PCB 100 sont rendus solidaires par un ajustement bloqué. L'extrémité press-fit présente par conséquent des dimensions adaptées aux trous métallisés 131 pour réaliser la fonction press-fit.

Plusieurs réalisations de cette extrémité press-fit peuvent être envisagées, comme décrites par la suite.

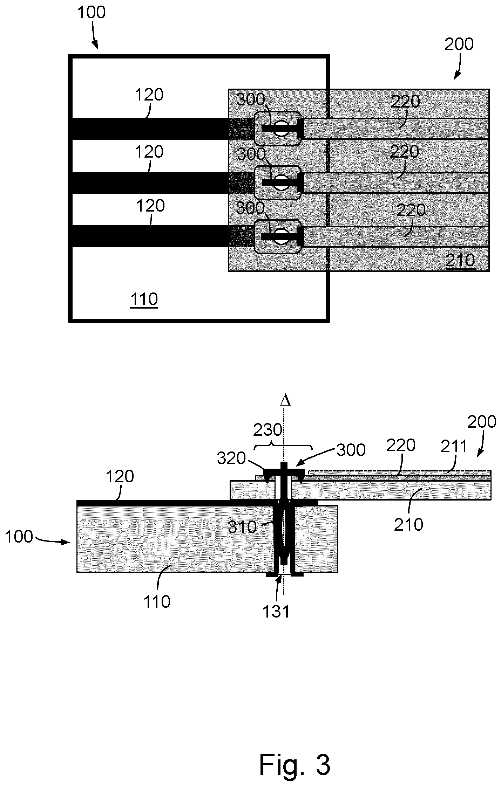

De l'autre côté, la tête 320 du T forme une autre extrémité, opposée à la première, formant zone ou portion d'appui visant à maintenir, par appui contre la zone de contact 230 du flex PCB 200, ce dernier contre le rigid PCB 100 comme expliqué par la suite et illustré par la **Figure 3****.**

De même, plusieurs réalisations de cette extrémité d'appui peuvent être envisagées, comme décrites par la suite.

Comme représenté en **Figure 2** par la flèche pleine, la broche de connexion 300 est engagée, extrémité press-fit 310 en avant, dans le passage 031 d'abord par le trou traversant 231 du flex PCB 200, puis dans le trou métallisé 131 qui lui fait face. Lorsque les zones de contact 230 sont vierges de trou traversant, c'est l'engagement de la broche de connexion 300 au niveau d'une zone de contact qui perfore ou transperce le flex PCB 200 et crée ainsi un trou traversant 231. A cet effet, le pied (extrémité press-fit 310) de la broche de connexion 300 présente une extrémité effilée, pointue et ou tranchante.

La broche de connexion 300, et notamment son extrémité press-fit 310, s'emmanche alors, i.e. est engagée en force, dans le trou métallisé 131 du rigid PCB 100, assurant un ajustement bloqué des deux pièces (broche et rigid PCB) entre elles. La **Figure 3** illustre l'état final du raccordement électrique une fois l'extrémité press-fit 310 emmanchée dans le trou métallisé 131.

Dans cet état final, l'extrémité opposée 320 de la broche de connexion maintient, par appui contre la zone de contact 230, le flex PCB 200 contre le rigid PCB 100. En effet, le flex PCB 200 est pris en sandwich ou en étau entre le rigid PCB 100 et la tête 320 de la broche qui présente une dimension supérieure à cette du passage 031. L'ajustement bloqué de la broche 300 avec le rigid PCB 100 par l'emmanchement de l'extrémité press-fit 310 dans le trou métallisé 131 garantit le placage, et donc le maintien, des deux PCB l'un contre l'autre.

Dans cette configuration, d'une part, la tête 320 de la broche de connexion 300 réalise un contact électrique avec la piste conductrice 220, au niveau de la zone de contact 230 et, d'autre part, l'extrémité press-fit 310 réalise un contact électrique avec la piste conductrice 120, via la métallisation du trou métallisé 131. Ainsi, la broche de connexion 300 établit, en soi, une connexion électrique entre les deux circuits imprimés 100 et 200, sans qu'il n'y ait besoin d'ajouter un connecteur ou autre manchon conducteur sur le flex PCB 100 avant raccordement.

Une machine d'insertion de broches press-fit permet un tel raccordement électrique entre flex PCB et rigid PCB, en réalisant notamment l'emmanchement simultané de plusieurs broches 300 (trois sur les Figures) prélevées d'un rouleau de broches en bande, dans des passages 031 agencés selon un pas prédéterminé.

Les **Figures 2** et **3** illustrent une broche press-fit de connexion 300 du type adaptable, c'est-à-dire qui se compresse ou est élastiquement déformable ou « s'adapte » au cours de l'insertion en force. L'invention s'applique également à des broches press-fit de type massives, encore appelées broches pleines ou broches solides.

La **Figure 3** illustre la broche press-fit adaptable dans un état comprimé, assurant l'ajustement bloqué. Par l'engagement en force de la broche dans le passage 031, il est classique que le trou métallisé 131 se trouve légèrement déformé (en particulier la couche de métal), améliorant le blocage.

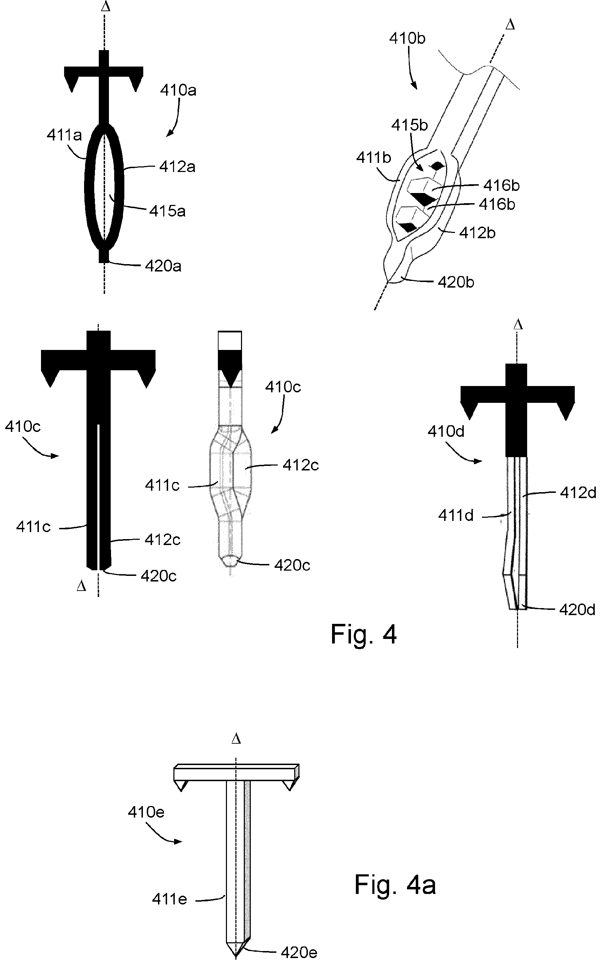

La **Figure 4** illustre quelques variantes de l'extrémité press-fit adaptable 310 d'une broche 300 adaptée à l'invention. D'autres variantes non illustrées ici sont également utilisables pour une mise en oeuvre de l'invention.

Ces broches sont de préférence fabriquées par découpe (découpe laser ou à jet d'eau, outil de découpe à suivre, découpe à la presse, etc.) d'une tôle conductrice ayant typiquement une épaisseur d'environ un demi millimètre, par exemple 0,635 mm. Un exemple de tôle conductrice comprend une tôle en acier inoxydable, en alliage de fer et de nickel, en cuivre, en alliage de cuivre telle bronze phosphoreux, ou équivalent. Ainsi, les broches 300 sont faites en une seule pièce.

L'extrémité press-fit 410a reprend celle des **Figures 2** et **3** et montre une portion press-fit 310 de type « eye of needle », EON, ou chas d'aiguille, symétrique par rapport à son axe longitudinal Δ. Cette broche est plane.

La portion press-fit EON 410a est composée de deux bras 411a, 412a en saillie latérale par rapport à l'axe longitudinal Δ, obtenus par la formation d'un trou 415a, s'apparentant ainsi à un chas d'aiguille à coudre. Par le choix d'un matériau adapté et d'une largeur des bras adaptée, ce trou offre une flexibilité, et donc un effet ressort, plus ou moins importante des bras. L'écartement entre les bords externes des deux bras 411a, 412a est supérieur au diamètre du passage 031, de sorte à nécessiter une insertion en force.

La pointe 420a, typiquement effilée ou conique, permet une insertion facilitée dans le passage 031.

L'extrémité press-fit 410b est une variante toujours de type EON symétrique par rapport à son axe longitudinal Δ, connue sous l'appellation de « MultiSpring » (multiple ressorts). Cette variante comprend en outre de multiples lamelles pliées 416b (obtenues par exemple par emboutissage après découpe), faisant office de ressorts, à l'intérieur du chas 415b. Typiquement, les lamelles sont alternativement en forme générale d'un V et en forme générale d'un V inversé (voire d'un W et d'un W inversé), et ne dépasse pas de l'épaisseur de la broche 330 (épaisseur définie par celle de la tôle dans laquelle elle est découpée).

A nouveau, la pointe 420b, typiquement effilée ou conique, permet une insertion facilitée dans le passage 031.

L'extrémité press-fit 410c est une variante de type « Action PIN » présentant deux bras ou lamelles ou « demi-broches » 411c, 412c décalés, typiquement par emboutissage, de l'axe longitudinal Δ, dans une direction perpendiculaire au plan de la broche (la représentation illustrée à droite est réalisée de côté, dans l'épaisseur de la broche). En variante, une seule des deux demi-broche peut être décalée, l'autre restant parallèle à l'axe. Ce décalage confère à la portion press-fit l'effet ressort nécessaire à l'insertion en force.

A nouveau, la pointe 420c, typiquement effilée ou conique, permet une insertion facilitée dans le passage 031.

L'extrémité press-fit 410d est une autre variante de type « Action PIN » présentant une seule demi-broche 411d décalée de l'axe longitudinal Δ, dans le plan de la broche (et non dans une direction perpendiculaire). La seconde demi-broche 412d est maintenue parallèle à l'axe longitudinal. En variante, les deux demi-broches peuvent être décalées de façon symétrique. Ce décalage confère à la portion press-fit l'effet ressort nécessaire à une insertion en force.

A nouveau, la pointe 420d, typiquement effilée ou conique, permet une insertion facilitée dans le passage 031.

La **Figure 4a** illustre une extrémité press-fit de type massive. La broche pleine ou solide comporte ici une extrémité press-fit 410e dont l'unique bras 411e est de section carrée et constante, à l'exception de la pointe terminale 420e, typiquement effilée ou conique, permettant une insertion facilitée dans le passage 031.

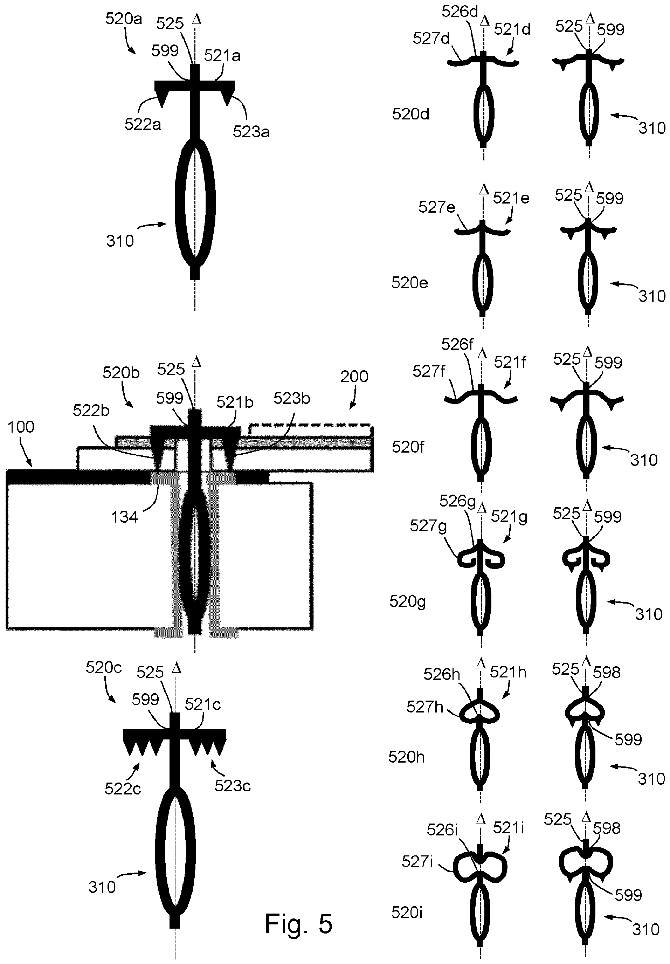

La **Figure 5** illustre quelques variantes de l'extrémité 320 formant zone ou portion d'appui d'une broche 300 où l'extrémité press-fit 310 est de type EON. Cependant, l'extrémité press-fit 310 de ces variantes peut être selon l'un quelconque des modes de réalisation décrits aux **Figures 4** et **4a****.**

La tête 520a reprend celle des **Figures 2** et **3** et montre une portion d'appui 320 formée par deux bras 521a (la barre du T) symétriques qui s'entend sensiblement perpendiculairement à l'axe longitudinal Δ depuis un point (ou zone) 599 d'où s'étend la portion press-fit 310. Au moins un bras de la portion d'appui 320 comporte, sur sa surface d'appui contre le flex PCB, au moins une dent 522a orientée vers l'extrémité press-fit 310. Typiquement deux dents 522a, 523a disposées de part et d'autre de l'axe longitudinal Δ (donc une par bras) sont prévues.

De telles dents confèrent à la portion d'appui 320 une zone irrégulière ou abrasive qui permet une accroche à la zone de contact 230 et donc un maintien du flex PCB 200. D'autres protubérances plus ou moins irrégulières que des dents peuvent être utilisées en variante, par exemple des demi-boules ou des picots semi-sphériques.

Avantageusement, cette ou ces dents pointues peuvent transpercer la couche isolante 211 qui peut recouvrir la zone de contact 230 afin de réaliser un contact électrique avec la piste conductrice 220 au niveau de cette zone de contact, voire transpercer la piste conductrice 220 elle-même au niveau de la zone de contact, lorsque le raccordement (**Figure 3**) a été réalisé.

De telles dents peuvent avoir une longueur inférieure à une demi-épaisseur du flex PCB 200, préférentiellement inférieure à un tiers de cette épaisseur. A titre illustratif, pour un flex PCB d'épaisseur totale 300 µm au niveau de la zone de contact, la longueur des dents peut être fixée à 80 µm.

L'extrémité supérieure de la tête 520a se termine par un doigt 525 qui s'étend depuis le point 599 le long de l'axe longitudinal Δ du côté opposé à la portion press-fit 310. Ce doigt permet typiquement la manipulation (saisie, déplacement) de la broche de connexion 300 par la machine d'insertion de broches press-fit.

La variante 520b présente des dents allongées configurées pour transpercer le flex PCB 200 dans son épaisseur (base 210, piste 220 et éventuel film isolant 211) au niveau de la zone de contact 230, lors du raccordement. En transperçant toute l'épaisseur, ces dents réalisent également un contact électrique avec une surface conductrice (notamment le débordement 134 de la métallisation du trou) du rigid PCB 100 aux abords du trou métallisé 131. Cela contribue à une meilleure interconnexion électrique entre les deux circuits imprimés.

La variante 520c présente deux réseaux 522c, 523c de dents disposés de part et d'autre de l'axe longitudinal Δ (sur les bras 521c), au lieu de dents isolées. Bien que trois dents soient illustrées par réseau, le nombre de dents par réseau peut être différent (2, 4 ou plus) et peut varier d'un réseau à l'autre.

En outre, tout ou partie des dents peuvent être dimensionnées pour transpercer ou non le flex PCB 200 dans toute son épaisseur (comme dans la variante 520b) ou seulement certaines couches (comme dans la variante 520a).

Dans les variantes 520d à 520i, la portion d'appui 320, toujours formée par deux bras symétriques 521d à 521i qui s'étendent sensiblement perpendiculairement à l'axe longitudinal Δ depuis le point 599, est élastiquement déformable agissant comme ressort pour solliciter la zone de contact 230, i.e. pour exercer l'effort d'appui contre celle-ci, lorsque l'extrémité press-fit 310 est engagée dans le passage 031 depuis le flex PCB 200 et est emmanchée dans le trou métallisé 131. La propriété élastique de ces portions d'appui peut être obtenue par un compromis bien choisi entre la largeur des bras (leur plus petite dimension dans le plan représenté sur les figures) et le matériau utilisé. De façon préférentielle, on utilise un métal présentant de bonnes caractéristiques élastiques, par exemple du bronze phosphoreux.

Dans ces variantes, la portion d'appui comprend une portion incurvée de matériau conducteur dont la surface convexe (surface inférieure sur les illustrations) officie comme surface d'appui contre la zone de contact 230, lorsque la broche 300 est emmanchée dans l'assemblage des deux circuits.

La surface d'appui de ces variantes peut être pourvue de dents ou irrégularités équivalentes évoquées ci-dessus (variantes à droite, le nombre de dents pouvant être autre que celui illustré, incluant des réseaux de dents) ou en être dépourvue (variantes à gauche).

Dans les variantes 520d à 520g, le doigt 525 de saisie de la broche s'étend depuis le point 599 d'où s'étendent à la fois les bras constituant portion d'appui 320 et la portion press-fit 310.

Dans la variante 520d, chaque bras 521d formant portion d'appui est constitué d'une première portion 526d de bras s'entendant perpendiculairement à l'axe longitudinal Δ depuis le point 599, et de la deuxième portion 527d incurvée s'étendant depuis l'extrémité de la première portion vers l'extérieur et dont la surface convexe (avec ou sans dent, orientée vers la portion press-fit 310) constitue la surface d'appui contre la zone de contact 230.

Dans la variante 520e, chaque bras 521e formant portion d'appui est constitué de la seule portion 527e incurvée qui s'étend depuis le point 599 et dont la surface convexe (avec ou sans dent) constitue la surface d'appui contre la zone de contact 230.

Dans la variante 520f, chaque bras 521f formant portion d'appui est constitué d'une première portion courbe 526e de bras s'entendant depuis le point 599 dont la concavité est orientée vers la portion press-fit 310, et d'une deuxième portion 527f incurvée s'étendant depuis l'extrémité de la première portion vers l'extérieur et dont la surface convexe (avec ou sans dent, orientée vers la portion press-fit 310) constitue la surface d'appui contre la zone de contact 230.

Dans la variante 520g, chaque bras 521g formant portion d'appui est constitué d'une première portion courbe 526g de bras s'entendant depuis le point 599 dont la concavité est orientée vers la portion press-fit 310, et d'une deuxième portion 527g incurvée s'étendant, depuis l'extrémité de la première portion, en forme générale d'un C ou d'un C inversé dirigé vers l'axe longitudinal Δ et dont une surface convexe (avec ou sans dent, orientée vers la portion press-fit 310) constitue la surface d'appui contre la zone de contact 230.

Dans les variantes 520h et 520i, le doigt 525 de saisie de la broche ne s'étend plus depuis le point 599, mais depuis une extrémité commune des bras d'appui formant boucle.

Dans ces variantes, les bras 521h/521i sont similaires aux bras 521f décrits ci-dessus si ce n'est que leurs deuxièmes portions 527h/527i incurvées s'étendant depuis l'extrémité de leurs premières portions 526h/526i se prolongent pour former une boucle en un point 598 sur l'axe Δ, duquel s'étend le doigt 525 de saisie. Le doigt 525 se trouve ainsi à distance du point 599 d'où s'étend la portion press-fit 310. La flexibilité des bras formant boucle permet de garder dans le temps suffisamment de pression desdits deux bras sur la zone de contact pour garantir le contact électrique.

La surface convexe (avec ou sans dent, orientée vers la portion press-fit 310) des deuxièmes portions 527h/527i constitue toujours la surface d'appui contre la zone de contact 230.

Dans la variante 520h, les deuxièmes portions 527h se prolongent de sorte à former une boucle en forme général d'un coeur inversé.

Dans la variante 520i, les deuxièmes portions 527i se prolongent de sorte à former une boucle en forme général d'un 8 à l'horizontal.

Bien que la présente invention ait été décrite ci-dessus en référence à des modes de réalisation spécifiques, la présente invention n'est pas limitée à ces modes de réalisation spécifiques, et des modifications, qui se trouvent dans la portée de la présente invention, seront visibles pour un homme du métier.

## Revendications

1. Procédé de raccordement électrique d'un circuit imprimé flexible (200) à un circuit imprimé rigide (100), comprenant les étapes suivantes :
- présenter une zone de contact (230) du circuit imprimé flexible, en regard d'un trou métallisé (131) du circuit imprimé rigide,
- engager une broche de connexion (300) en matériau conducteur au travers de la zone de contact (230) du circuit imprimé flexible de sorte qu'une première extrémité (310) de type à emmanchement ou « press-fit » de la broche de connexion s'emmanche dans le trou métallisé du circuit imprimé rigide, et qu'une extrémité opposée (320) de la broche de connexion maintient, par appui contre la zone de contact, le circuit imprimé flexible contre le circuit imprimé rigide de sorte à réaliser une connexion électrique entre les deux circuits imprimés,
procédé dans lequel une portion d'appui (320) réalisant l'appui de l'extrémité opposée de la broche de connexion sur la zone de contact (230) comporte au moins une protubérance (522a, 523a, 522b, 523b, 522c, 523c), telle une dent, une demi-boule ou un picot semi-sphérique, orientée vers la première extrémité (310)..

2. Procédé selon la revendication 1, dans lequel le circuit imprimé flexible (200) comporte un trou traversant (231) réalisé au niveau de la zone de contact, lequel trou traversant est aligné avec le trou métallisé (131) avant d'engager la broche de connexion (300).

3. Procédé selon la revendication 1 ou 2, dans lequel ladite au moins une protubérance est une dent configurée pour transpercer une couche isolante (210, 211) et/ou une piste conductrice (220) du circuit imprimé flexible (200) au niveau de la zone de contact (230), lorsque la première extrémité (300) est emmanchée dans le trou métallisé (131) du circuit imprimé rigide (100).

4. Procédé selon la revendication 1 ou 2, dans lequel ladite au moins une protubérance est une dent configurée pour transpercer le circuit imprimé flexible (200) au niveau de la zone de contact (230), lorsque la première extrémité est emmanchée dans le trou métallisé, de sorte à réaliser un contact électrique avec une surface conductrice (134) du circuit imprimé rigide aux abords du trou métallisé (131).

5. Procédé selon l'une des revendications 1 à 5, dans lequel ladite au moins une protubérance comporte deux dents disposées de part et d'autre d'un axe longitudinal (Δ) de la broche de connexion (300) formé par lesdites deux extrémités.

6. Procédé selon l'une des revendications 1 à 5, dans lequel ladite au moins une protubérance comporte deux réseaux de dents (522c, 523c) disposés de part et d'autre d'un axe longitudinal (Δ) de la broche de connexion (300) formé par lesdites deux extrémités.

7. Procédé selon l'une des revendications précédentes, dans lequel l'extrémité opposée (320) de la broche de connexion (300) comporte une portion d'appui (520a-i) élastiquement déformable agissant comme ressort pour exercer un effort d'appui pour ledit appui contre la zone de contact (230), lorsque la première extrémité (310) est emmanchée dans le trou métallisé (131).

8. Procédé selon la revendication 7, dans lequel la portion d'appui élastiquement déformable est symétrique par rapport à un axe longitudinal (Δ) de la broche de connexion (300) formé par lesdites deux extrémités.

9. Procédé selon l'une des revendications précédentes, dans lequel la broche de connexion (300) est configurée en forme générale d'un T, le pied du T formant la première extrémité (310) de type à emmanchement et la tête du T formant l'extrémité opposée (320) maintenant, par appui contre la zone de contact (230), le circuit imprimé flexible contre le circuit imprimé rigide.

10. Assemblage électrique comportant :
- un circuit imprimé rigide (100) présentant un trou métallisé (131),
- un circuit imprimé flexible (200) présentant un trou traversant (231) réalisé au niveau d'une zone de contact (230) et disposé en regard du trou métallisé, et
- une broche de connexion (300) en matériau conducteur dont une première extrémité (310) de type à emmanchement ou « press-fit » de la broche est emmanchée dans le trou métallisé du circuit imprimé rigide, et une extrémité opposée (320) maintient, par appui contre la zone de contact, le circuit imprimé flexible contre le circuit imprimé rigide de sorte à réaliser une connexion électrique entre les deux circuits imprimés,
assemblage électrique dans lequel une portion d'appui (320) réalisant l'appui de l'extrémité opposée de la broche de connexion sur la zone de contact (230) comporte au moins une protubérance (522a, 523a, 522b, 523b, 522c, 523c), telle une dent, une demi-boule ou un picot semi-sphérique, orientée vers la première extrémité (310).

11. Broche de connexion (300) d'un circuit imprimé flexible (200) à un circuit imprimé rigide (100), la broche de connexion étant réalisée en matériau conducteur et comprenant :
- une première extrémité (310) de type à emmanchement ou « press-fit » apte à être emmanchée dans un trou métallisé (131) du circuit imprimé rigide, et
- une deuxième extrémité de connexion (320) comprenant une portion d'appui (520a-i) configurée pour, lorsque la première extrémité traverse un trou réalisé au niveau d'une zone de contact (230) du circuit imprimé flexible puis est emmanchée dans le trou métallisé du circuit imprimé rigide, maintenir, par appui contre la zone de contact (230) du circuit imprimé flexible, le circuit imprimé flexible contre le circuit imprimé rigide de sorte à réaliser une connexion électrique entre les deux circuits imprimés,
broche de connexion (300) dans laquelle la portion d'appui :
- comporte au moins une dent (522a, 523a, 522b, 523b, 522c, 523c) pour transpercer une couche isolante (210, 211) et/ou une piste conductrice (220) du circuit imprimé flexible au niveau de la zone de contact, lorsque la première extrémité est emmanchée dans le trou métallisé.

12. Broche de connexion (300) selon la revendication 11, dans laquelle la portion d'appui est en outre élastiquement déformable agissant comme ressort pour exercer un effort d'appui pour ledit appui contre la zone de contact, lorsque la première extrémité est emmanchée dans le trou métallisé.
